# EUROPÄISCHE PATENTANMELDUNG

(11) **EP 1 630 876 A2**
(43) Veröffentlichungstag der Anmeldung: **01.03.2006**
(21) Anmeldenummer: 05018022.3
(22) Anmeldetag: 19.08.2005
(51) Int. Cl.: H01L 33/00, F21V 7/00, F21V 5/00, G02B 17/08, F21Y 101/02

(54) **Leuchteinheit mit einer Vielzahl gekrümmter Flächenelemente**

(30) Priorität: 30.08.2004 DE 102004042125
(71) Anmelder: Schefenacker Vision Systems Germany GmbH, 73730 Esslingen (DE)
(72) Erfinder: Stefanov, Emil, Dr., 73730 Esslingen (DE); Luce, Thomas, Dr., 73730 Esslingen (DE); Erber, Andreas, 73734 Esslingen (DE); Kunze, Jochen, 47441 Moers (DE)
(74) Vertreter: Schmid, Rudolf

(57) **Zusammenfassung**

Die Erfindung betrifft eine Leuchteinheit mit mindestens einer Lichtquelle (10) und mindestens einem der Lichtquelle nachgeschalteten und diese zumindest bereichsweise umgebenden Lichtleitkörper (20), wobei der Lichtleitkörper (20) mindestens eine der Lichtquelle (10) abgewandte, zumindest annähernd zentral liegende Lichtaustrittsfläche (41) umfasst, die von mindestens einer außenliegenden Lichtaustrittsfläche (51) umgeben ist. Dazu weist zumindest eine außenliegende Lichtaustrittsfläche eine Vielzahl aneinander mit oder ohne Absatz angrenzender Flächenelemente (52) auf. Diese Flächenelemente sind Oberflächenbereiche gekrümmter Raumkörper.

Mit der vorliegenden Erfindung wird eine kompakte Leuchteinheit entwickelt, die eine gleichmäßig hohe Lichtausbeute in einem vorgeschriebenen Zielgebiet ermöglicht.

## Beschreibung

Die Erfindung betrifft eine Leuchteinheit mit mindestens einer Lichtquelle und mindestens einem der Lichtquelle nachgeschalteten und diese zumindest bereichsweise umgebenden Lichtleitkörper, wobei der Lichtleitkörper mindestens eine der Lichtquelle abgewandte, zumindest annähernd zentral liegende Lichtaustrittsfläche umfasst, die von mindestens einer außenliegenden Lichtaustrittsfläche umgeben ist.

Aus der US 2,254,961 sind derartige Leuchteinheiten bekannt. Diese Leuchteinheiten beleuchten in einem Zielgebiet, das normal zur Abstrahlrichtung der Leuchteinheit steht und von dieser beschienen wird, annähernd kreisflächige Zonen. Soll ein rechteckiges Zielgebiet ausgeleuchtet werden, ist ein großer Reflektor erforderlich.

Der vorliegenden Erfindung liegt daher die Problemstellung zugrunde, eine kompakte Leuchteinheit zu entwickeln, die eine gleichmäßig hohe Lichtausbeute in einem vorgeschriebenen Zielgebiet ermöglicht.

Diese Problemstellung wird mit den Merkmalen des Hauptanspruches gelöst. Dazu weist zumindest eine außenliegende Lichtaustrittsfläche eine Vielzahl aneinander mit oder ohne Absatz angrenzender Flächenelemente auf. Diese Flächenelemente sind Oberflächenbereiche gekrümmter Raumkörper.

Weitere Einzelheiten der Erfindung ergeben sich aus den Unteransprüchen und der nachfolgenden Beschreibung schematisch dargestellter Ausführungsformen.
- Figur 1:: Dimetrische Ansicht einer Leuchteinheit;
- Figur 2:: Vorderansicht der Leuchteinheit nach Figur 1;
- Figur 3:: Schnitt durch die Leuchteinheit nach Figur 1;
- Figur 4:: Teilschnitt einer Lichtaustrittsfläche;
- Figur 5:: Teilschnitt einer Lichtaustrittsfläche mit Absätzen;
- Figur 6:: Teilschnitt einer Lichtaustrittsfläche für eine asymmetrische Lichtstärkenverteilung;
- Figur 7:: Teilschnitt einer Lichtaustrittsfläche mit unterschiedlichen Flächenelementen.

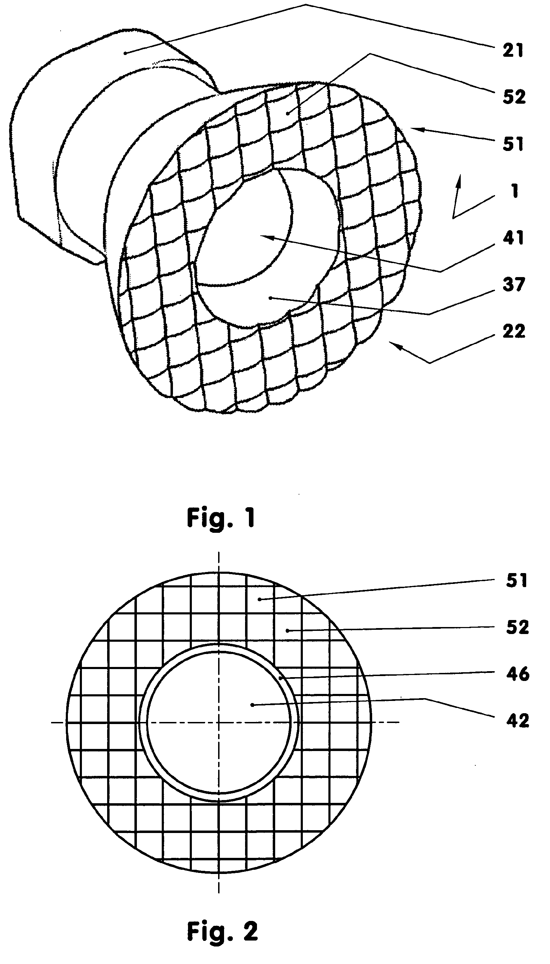

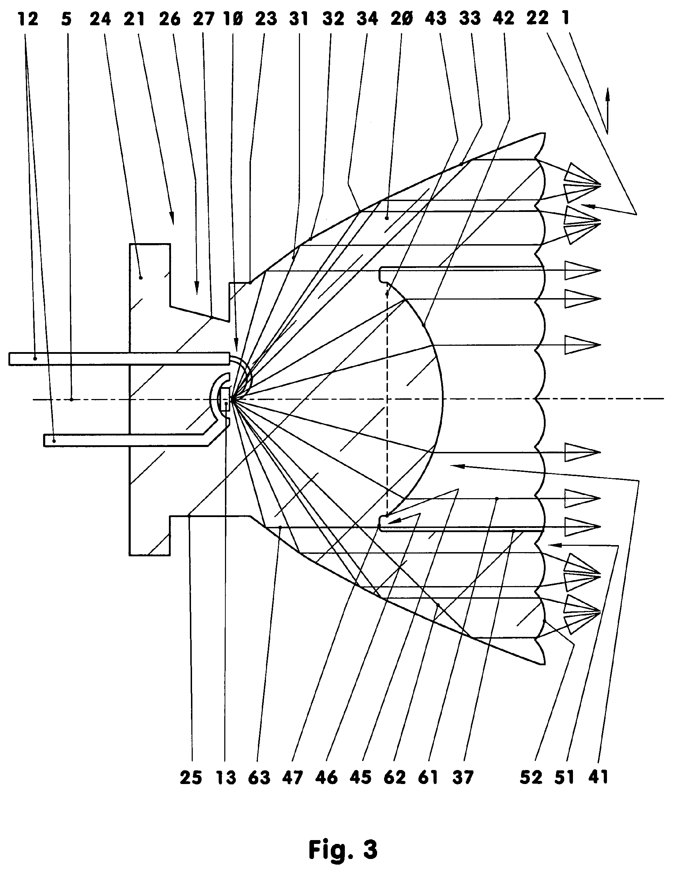

Die Figuren 1 bis 3 zeigen eine dimetrische Darstellung, eine Vorderansicht und einen Längsschnitt durch eine Leuchteinheit. Die Leuchteinheit umfasst eine Lichtquelle (10) und einen, der Lichtquelle (10) optisch nachgeschalteten Lichtleitkörper (20).

Die Lichtquelle (10) ist beispielsweise eine Leuchtdiode (10). Diese besteht z.B. aus einem lichtemittierenden Halbleiterchip (13) organischer oder anorganischer Art, der von einer Kunststoffschicht umgossen oder umspritzt ist. Am lichtemittierenden Chip (13) sind elektrische Anschlüsse (12) befestigt, die aus der Kunststoffschicht herausragen.

Anstatt einer Leuchtdiode (10) kann als Lichtquelle (10) auch eine Laserdiode, eine Halogenbirne, eine Glühbirne, etc. eingesetzt werden.

Die Leuchtdiode (10) wird vom Lichtverteilkörper (20) umgeben, in den die Leuchtdiode (10) z.B. mittels Spritzgießen eingeformt oder an den die Leuchtdiode (10) angeformt ist. Der Lichtverteilkörper (20) umgibt die Leuchtdiode (10) zumindest bereichsweise.

Der Lichtleitkörper (20) ist beispielsweise ein weitgehend rotationssymmetrischer Kunststoffkörper z.B. aus PMMA, PMMI oder einem anderen optisch klaren thermoplastischen Kunststoff. Er hat einen Sockel (21) und einen Abschnitt (31), dessen Außendurchmesser über seine Länge von einer Überganskante (23) zu einer der Leuchtdiode (10) abgewandten Lichtaustrittsseite (22) hin zunimmt. Die optische Achse (5) der Leuchteinheit fällt beispielsweise mit der Mittellinie des Lichtverteilkörpers (20) zusammen.

Der Sockel (21) hat z.B. einen Anlageflansch (24) an den sich ein zumindest bereichsweise zylindrischer Abschnitt (25) anschließt. Am zylindrischen Abschnitt (25) ist eine in Umfangsrichtung orientierte Kerbe (26) mit schrägem Kerbgrund (27) angeordnet. Die Länge des zylindrischen Abschnitts (25) kann bis zur Hälfte der Länge des Lichtverteilkörpers (20) betragen. Sein Durchmesser kann größer sein als die Hälfte des maximalen Durchmessers des Lichtverteilkörpers (20).

Der Abschnitt (31) zunehmenden Durchmessers ist in diesem Ausführungsbeispiel ein Paraboloidstumpf. Dieser Abschnitt (31) kann auch eine hyperboloidförmige, kegelstumpfförmige oder eine andere Gestalt haben. Er kann so ausgeformt sein, dass die Mantelfläche (32) keinen gemeinsamen Brennpunkt hat. Die Mantelfläche (32) kann so ausgebildet sein, dass von der Lichtquelle (10) ausgesandtes Licht an der Grenzfläche (33) zwischen dem Werkstoff des Lichtverteilkörpers (20) und der Umgebung (1) vollständig reflektiert wird. Bei PMMI beträgt der Grenzwinkel für die Totalreflexion beispielsweise ca. 43 Grad.

Der Paraboloidstumpf (31) ist z.B. zwischen 4 und 8 mm lang. Der Durchmesserbereich der Lichtaustrittsseite (22) liegt beispielsweise zwischen 7 und 14 mm.

Die Lichtaustrittsseite (22) umfasst im hier dargestellten Ausführungsbeispiel eine zentral liegende Lichtaustrittsfläche (41), die von einer außenliegenden Lichtaustrittsfläche (51) umgeben ist.

Die zentrale Lichtaustrittsfläche (41) ist z.B. die Oberfläche einer asphärischen Sammellinse (42), die normal zur optischen Achse (5) der Leuchteinheit angeordnet ist. Ihr Durchmesser beträgt an der fiktiven Grundfläche (43) etwa 40% des Durchmessers der Lichtaustrittsseite (22). Der Abstand der Grundfläche (43) zur Lichtquelle (10) beträgt etwa 40% der Länge des Lichtleitkörpers (20). Dieser Abstand ist größer als der Abstand der Grundfläche (43) zum Brennpunkt der Sammellinse (42). Die Grundfläche (43) und die Oberfläche der Sammellinse (42) schneiden sich in einer Begrenzungskante (45). Diese Begrenzungskante (45) sowie die Kontur des lichtemittierende Chips (13) sind mathematische Leitkurven eines Raumkörpers, z.B. im Spezialfall eines Kegels, dessen gegenüberliegenden Mantellinien beispielsweise einen Winkel von 90 Grad einschließen.

Um die Begrenzungskante (45) herum ist als Entformungskehle eine Hohlkehle (46) angeordnet. Die Hohlkehle (46) weist beispielsweise über ihre Länge einen konstanten Querschnitt auf. Sie hat z.B. einen waagerechten Kehlgrund (47), der normal zur optischen Achse (5) angeordnet ist. In radialer Richtung nach außen wird die Hohlkehle (46) durch einen Hohlzylinder (37) begrenzt. Der Kehlgrund (47) geht in Übergangskehlen in die angrenzenden Flächen über.

Die zentrale Lichtaustrittsfläche (41) kann auch die Oberfläche einer Streulinse, einer Fresnellinse, einer Planlinse, etc. sein. Statt einer einzelnen optischen Linse (42) können mehrere optische Linsen z.B. nebeneinander angeordnet sein. Die zentrale Lichtaustrittsfläche (41) kann auch optische Strukturen aufweisen.

Die außenliegende Lichtaustrittsfläche (51) ist beispielweise ebenfalls normal zur optischen Achse (5) orientiert. Diese Lichtaustrittsfläche (51) kann gegenüber der optischen Achse (5) auch geneigt sein, kegelmantelförmig oder gewölbt ausgebildet sein, etc. Auch können einzelne Bereiche der Lichtaustrittsfläche (51) unterschiedliche Wölbungen aufweisen. Es ist auch denkbar, dass die Lichtaustrittsseite (22) mehrere z.B. ringförmige Lichtaustrittsflächen (51) umfasst, die versetzt zueinander angeordnet sind. Die Mittellinien dieser Lichtaustrittsflächen (51) liegen dann beispielsweise auf der optischen Achse (5).

Die außenliegenden Lichtaustrittsfläche (51) ist eingeteilt in einzelne Flächenelemente (52), die beispielsweise aneinander angrenzend in Spalten und Reihen angeordnet sind. In dem in den Figuren 1 bis 3 dargestellten Ausführungsbeispiel sind die einzelnen Flächenelemente (52) - von vorne gesehen - quadratisch und haben eine Kantenlänge von einem Millimeter, wobei die Flächenelemente (52) in den Randbereichen entsprechend der äußeren Kontur des Lichtverteilkörpers (20) und des Hohlzylinders (37) beschnitten sind. Die Lichtaustrittsfläche (51) der dargestellten Leuchteinheit weist so z.B. 80 Flächenelemente (52) auf.

Anstatt in einer karthesischen Anordnung können die Flächenelemente (52) auch in Spalten oder Reihen versetzt zueinander liegen, sie können polar, spiralförmig, etc. angeordnet sein. Ihre Flächen können rund, dreieckig, rechteckig, sechseckig, ellipsenförmig, etc. sein.

Die in den Figuren 1 bis 3 gezeigten Flächenelemente (52) haben beispielsweise parallel zur optischen Achse (5) eine Höhe zwischen einem und drei Zehntel Millimetern. Die Höhe ist beispielsweise abhängig vom Brechungsindex des Werkstoffs des Lichtverteilkörpers (20) gegenüber der Umgebung (1). Bei einem hohen Brechungsindex genügt beispielsweise eine geringe Höhe, bei einem niedrigen Brechungsindex ist eine große Höhe erforderlich.

Alle Flächenelemente (52) sind z.B. Oberflächenbereiche eines Ellipsoiden. Beispielsweise sind sie jeweils derselbe Oberflächenbereich des Ellipsoiden. Die drei Achsen des Ellipsoiden liegen hier normal zueinander und sind unterschiedlich lang, wobei die kürzeste Achse etwa ein Drittel der Länge der längsten Achse hat und die zweite Achse etwa 60% der Länge der längsten Achse aufweist. Die Länge der längsten Achse beträgt beispielsweise 4,2 Millimeter.

Die jeweils ein Flächenelement (52) aufspannenden, einander entsprechenden Achsen aller gedachten Ellipsoiden liegen in diesem Ausführungsbeispiel parallel zueinander, so dass alle Flächenelemente (52) in die gleiche Richtung ausgerichtet sind. Beispielsweise liegt in der Darstellung der Figur 2 die größte Krümmung der Flächenelemente (52) in einer waagerechten Querebene der Leuchteinheit.

Die Flächenelemente (52) können auch Oberflächenbereiche von Tonnen, Zylindern, Kegeln, Toren, oder anderen beliebig gekrümmten Raumkörpern sein. Sie können auch Oberflächenbereiche von Kombinationen verschiedener Körper sein. Die Flächenelemente (52) können stetige und unstetige Bereiche aufweisen, etc.

Beim Betrieb der Beleuchtungseinheit wird Licht von der Leuchtdiode (10) in Richtung der Lichtaustrittsseite (22) emittiert. Von dem vom lichtemittierenden Chip (13) ausgesandten Licht sind hier beispielsweise vereinfacht einzelne Strahlen (61 - 63) dargestellt. Die Lichtstrahlen (61), die z.B. innerhalb eines Kegels mit einem Winkel von beispielsweise 45 Grad zur optischen Achse (5) emittiert werden, durchdringen den homogenen Lichtleitkörper (20) und treffen hier in einem Winkel zwischen z.B. 0 Grad und 15 Grad zur Normalen im Auftreffpunkt auf die Sammellinse (42). Beim Austritt aus der Sammellinse (42) werden die Lichtstrahlen (61) beispielsweise in Richtung der optischen Achse (5) derart gebrochen, dass die Lichtstrahlen (61) nach dem Austritt aus der Sammellinse (42) zumindest annähernd parallel zueinander liegen.

Lichtstrahlen (62), die außerhalb dieses Kegels emittiert werden, treffen von innen an einem Punkt (34) auf die Mantelfläche (32) des Lichtleitkörpers (20) auf. Sie werden dort in Richtung der außenliegenden Lichtaustrittsfläche (51) reflektiert. Beim Durchtritt durch die Flächenelemente (52) werden sie vom Lot im Auftreffpunkt weg gebrochen. In der Umgebung (1) divergieren sie.

Lichtstrahlen (63), die in einem Winkel von z.B. etwa 75 Grad zur optischen Achse (5) von der Lichtquelle (10) emittiert werden, treffen auf die Mantelfläche (32) in der Nähe der Übergangskante (23) auf. Hier werden sie reflektiert und treten durch den Kehlgrund (47) in die Umgebung (1). Weiteres Streulicht wird beispielsweise, hier nicht dargestellt, im Sockel (21) reflektiert.

Wird beispielsweise die in der Figur 2 dargestellte Leuchteinheit so eingesetzt, dass der in der Zeichnung obenliegende Bereich oben ist, leuchtet diese Leuchteinheit z.B. annähernd ein Rechteck aus, dessen Breite doppelt so groß ist wie seine Höhe. Beispielsweise wird von der Leuchteinheit ein Raumwinkelbereich von +/- 20 Grad in der Breite und +/- 10 Grad in der Höhe mit hoher Lichtstärke ausgeleuchtet.

Aufgrund der geringen Lichtverluste erreicht ein hoher Lichtstrom das Zielgebiet. Beim Einsatz beispielsweise in einem Kraftfahrzeug können so die von den jeweiligen nationalen Gesetzgebern vorgeschriebenen Lichtstärkenverteilungen erzeugt werden.

Das auszuleuchtende Zielgebiet kann auch oval, elliptisch, dreieckig etc. sein. Um dieses auszuleuchten, kann beispielsweise auch die zentrale Lichtaustrittsfläche (41) Flächenelemente aufweisen, die Oberflächenbereiche gekrümmter Raumkörper sind.

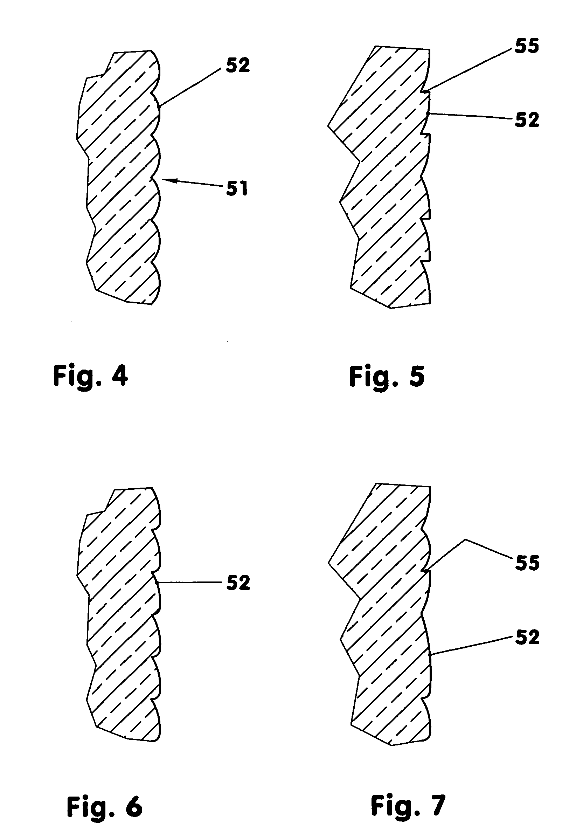

Die Figuren 4 bis 7 zeigen Teilschnitte von Lichtaustrittsflächen (51).

In der Figur 4 sind die einzelnen Flächenelemente (52) Oberflächenbereiche von Ellipsoiden. Diese Flächenelemente (52) grenzen ohne Absatz aneinander an.

Die in der Figur 5 dargestellte Lichtaustrittsfläche (51) hat z.B. Flächenelemente (52), die Oberflächenbereiche von Halbellipsoiden sind. Die einzelnen Flächenelemente (52) grenzen mit Absatz (55) aneinander. Diese Absätze (55) zeigen in der Darstellung der Figur 5 im oberen Bereich nach oben, im unteren Bereich nach unten. Die beiden mittleren Flächenelemente (52) grenzen ohne Absatz aneinander.

Mit der in Figur 6 dargestellten Lichtaustrittsfläche (51) lässt sich beispielsweise eine Leuchteinheit realisieren, die ein asymmetrisches Zielgebiet ausleuchtet. In diesem Fall würde die Leuchteinheit nach unten leuchten.

Die verschiedenen Gestalten der Flächenelemente (52) können auch miteinander kombiniert werden, wie die Figur 7 zeigt. Die einzelnen Flächenelemente (52) haben hier beispielsweise auch eine unterschiedliche Ausdehnung.

Die Leuchteinheit kann zusätzliche optische Linsen aufweisen, die der zentralen (41) und/oder der außenliegenden Lichtaustrittsfläche (51) optisch nachgeschaltet sind.

Die Leuchteinheit ermöglicht eine gezielte Lichtverteilung bei einem kompakten Aufbau. Aufgrund des hohen Lichtstroms im Zielgebiet ist z.B. für das Bremslicht eines Fahrzeugs nur eine geringe Anzahl von Leuchteinheiten erforderlich.

### Bezugszeichenliste:

- 1: Umgebung, Luft

- 5: optische Achse

- 10: Lichtquelle, Leuchtdiode
- 12: elektrische Anschlüsse
- 13: lichtemittierender Chip

- 20: Lichtleitkörper, Lichtverteilkörper
- 21: Sockel
- 22: Lichtaustrittsseite
- 23: Übergangskante
- 24: Anlageflansch
- 25: zylindrischer Abschnitt
- 26: Kerbe
- 27: Kerbgrund

- 31: Abschnitt von (20), Paraboloidstumpf
- 32: Mantelfläche
- 33: Grenzfläche
- 34: Punkt von (32)

- 37: Hohlzylinder

- 41: zentrale Lichtaustrittsfläche
- 42: optische Linse, Sammellinse
- 43: Grundfläche

- 45: Begrenzungskante
- 46: Entformungskehle, Hohlkehle
- 47: Kehlgrund

- 51: außenliegende Lichtaustrittsfläche
- 52: Flächenelemente

- 55: Absatz

- 61: Lichtstrahlen durch (42)
- 62: Lichtstrahlen
- 63: Lichtstrahlen

## Patentansprüche

1. Leuchteinheit mit mindestens einer Lichtquelle und mindestens einem der Lichtquelle nachgeschalteten und diese zumindest bereichsweise umgebenden Lichtleitkörper, wobei der Lichtleitkörper mindestens eine der Lichtquelle abgewandte, zumindest annähernd zentral liegende Lichtaustrittsfläche umfasst, die von mindestens einer außenliegenden Lichtaustrittsfläche umgeben ist, **dadurch gekennzeichnet,**
- **dass** zumindest eine außenliegende Lichtaustrittsfläche (51) eine Vielzahl aneinander mit oder ohne Absatz (55) angrenzender Flächenelemente (52) aufweist und
- **dass** diese Flächenelemente (52) Oberflächenbereiche gekrümmter Raumkörper sind.

2. Leuchteinheit nach Anspruch 1, **dadurch gekennzeichnet, dass** die Lichtquelle (10) eine Leuchtdiode (10) ist.

3. Leuchteinheit nach Anspruch 1, **dadurch gekennzeichnet, dass** der einzelne gekrümmte Raumkörper ein Ellipsoid ist.

4. Leuchteinheit nach Anspruch 1, **dadurch gekennzeichnet, dass** die Flächenelemente (52) karthesisch angeordnet sind.

5. Leuchteinheit nach Anspruch 1, **dadurch gekennzeichnet, dass** alle Flächenelemente (52) gleiche Oberflächenbereiche des identischen gekrümmten Raumkörpers sind.

6. Leuchteinheit nach Anspruch 1, **dadurch gekennzeichnet, dass** eine zentrale Lichtaustrittsfläche (41) eine optische Linse (42) umfasst.

7. Leuchteinheit nach Anspruch 1, **dadurch gekennzeichnet, dass** die zentrale Lichtaustrittsfläche (41) eine Vielzahl aneinander angrenzender Flächenelemente aufweist, die Oberflächenbereiche gekrümmter Raumkörper sind.

8. Leuchteinheit nach Anspruch 1, **dadurch gekennzeichnet, dass** der Mantel (32) des Lichtleitkörpers (20) rotationssymmetrisch zur optischen Achse (5) ist und dass der Durchmesser der zentralen Lichtaustrittsfläche (41) 40% des Durchmessers des Lichtleitkörpers (20) beträgt.

9. Leuchteinheit nach Anspruch 1, **dadurch gekennzeichnet, dass** der Lichtleitkörper (20) einen Paraboloidstumpf (31) umfasst.
